Europäisches Patentamt

European Patent Office

Office européen des brevets

(19)

(11) Veröffentlichungsnummer: **0 019 780**
**B1**

(12) # EUROPÄISCHE PATENTSCHRIFT

(45) Veröffentlichungstag der Patentschrift:
08.06.83

(51) Int. Cl.³: H 05 K 7/20

(21) Anmeldenummer: 80102575.0

(22) Anmeldetag: 09.05.80

(54) **Kühlvorrichtung für elektronische Schaltkreis-Moduln.**

(30) Priorität: 29.05.79 US 43404

(43) Veröffentlichungstag der Anmeldung:
10.12.80 Patentblatt 80/25

(45) Bekanntmachung des Hinweises auf die Patenterteilung:
08.06.83 Patentblatt 83/23

(84) Benannte Vertragsstaaten:
AT BE DE FR GB NL

(56) Entgegenhaltungen:

US-A-3 843 910

IBM TECHNICAL DISCLOSURE BULLETIN, Band 21, Nr. 5, Oktober 1978, New York, U.S.A.,
V.Y. DOO: «High Capacity Power Dissipation Semiconductor Package»
IBM TECHNICAL DISCLOSURE BULLETIN, Band 21 Nr. 2, Juli 1978, New York, U.S.A.,
V.Y. DOO: «High Performance Package for Memory»

(73) Patentinhaber: International Business Machines Corporation, Armonk, N.Y. 10504 (US)

(72) Erfinder: Dunn, Robert Matthew, 193 Dorothy Street, Endicott New York 13760 (US)
Erfinder: Schulman, Martin David, 21 Old English Way, Wappingers New York 12590 (US)
Erfinder: Timko Jr., Nicholas, 21 Enid Place, Johnson City New York 13790 (US)

(74) Vertreter: Herzog, Joachim, Dipl.-Ing, Schönaicher Strasse 220, D-7030 Böblingen (DE)

## Kühlvorrichtung für elektronische Schaltkreis-Moduln

Die Erfindung bezieht sich auf eine Kühlvorrichtung für elektronische Schaltkreis-Moduln, von denen mehrere auf einem Träger angeordnet sind, wobei als Kühlmittel Luft verwendet wird, mit einer Luftkammer, der Kühlluft mit relativ konstantem Druck zugeführt wird und die mit einer Reihe von Auslässen gegenüber den Moduln versehen ist, wobei die Kühlluft beim Austritt aus den Auslässen direkt die zugeordneten Moduln anbläst. Eine derartige Kühlvorrichtung ist in der US-A-3 843 910 beschrieben.

Das Problem der effizienten Ableitung der Wärme von elektronischen Schaltkreismoduln bei höchstintegrierten elektronischen Schaltkreisen behinhaltet eine ganz erhebliche Begrenzung hinsichtlich der Entwicklungsmöglichkeiten und dem Gebrauch solcher elektronischer Moduls. Das Fehlen von effizienter Wärmeableitung begrenzt ernsthaft die Geschwindigkeit und die Leistungsfähigkeiten elektronischer Schaltkreismoduls. Dies wird dann um so einschneidender und bedeutender, wenn ein einzelnes elektronisches Schaltkreismodul eine ganze Anzahl von integrierten Chips sowie zugehörige Schaltkreise enthält.

Der Erfindung liegt die Aufgabe zugrunde, im Anströmverfahren die Schaltkreismoduln effektiv direkt zu kühlen, die verbrauchte bzw. aufgeheizte Luft ohne wesentliche Berührung mit anderen zu kühlenden Moduln abzuführen, eine Anordnung zu schaffen, die im Aufbau einfach ist, die wenig Lärm verursacht, die in ihrer Kühlwirkung positionsunabhängig ist und die relativ geringe Verluste durch effektive Ausnützung der Kühlluft aufweist.

Die Aufgabe wird dadurch gelöst, dass die von der Kühlluft abgeblasene Oberfläche der Moduln mit einer Turbulenzen erzeugenden Wärmeableitvorrichtung versehen ist, dass der Kühlluftstrom unter Turbulenzbildung durch die Wärmeableitvorrichtung hindurch auf die Oberfläche der Moduln geführt wird und dass die in der Wärmeableitvorrichtung erwärmte Luft durch kanalartige Zwischenräume zwischen den Moduln abgeleitet wird, ohne auf andere, benachbarte Moduln wesentlich zu treffen.

Vorteilhafte Ausführungsarten der Erfindung sind in den Ansprüchen 2 bis 8 angegeben.

Die durch die Erfindung erreichten Vorteile sind im wesentlichen darin zu sehen, dass die zu kühlenden Moduln positionsunabhängig angeordnet werden können, dass sie durch die direkt anströmende Luft effektiv gekühlt werden, dass durch die Druckverhältnisse sichergestellt ist, dass die verbrauchte Luft durch die Zwischenräume zwischen den Moduln abgeführt wird, ohne dass sie Kühlflächen anderer Moduln umströmt und diese somit wesentlich beeinflusst, dass mit Verwendung relativ vielen Luftdurchsatzes bei niedrigem Druck die Geräuschentwicklung stark herabgesetzt ist.

Im folgenden wird die Erfindung anhand von lediglich einen Ausführungsweg darstellenden Zeichnung näher erläutert.

Es zeigen:

Fig. 1 in perspektivischer Ansicht, teilweise im Schnitt, eine Anordnung mit elektronischen Schaltkreismoduln und Kühlvorrichtung;

Fig. 2 in Draufsicht einen Ausschnitt auf elektronische Schaltkreismoduln, um die Richtung des Luftflusses darzustellen, der als Ergebnis des direkt anströmenden Kühlstroms in der Kühlvorrichtung der einzelnen Moduln entsteht, und

Fig. 3 ein Diagramm, das die Beziehung zwischen dem Druckabfall und dem Luftfluss zeigt und zwar einmal bei einem Reihenfluss-Kühlsystem, bei dem die Luft hintereinander über mehrere zu kühlenden Elemente streicht, und zum anderen bei einem Kühlsystem, bei dem das zu kühlende Element direkt angeströmt wird, bezeichnet als direkter Fluss.

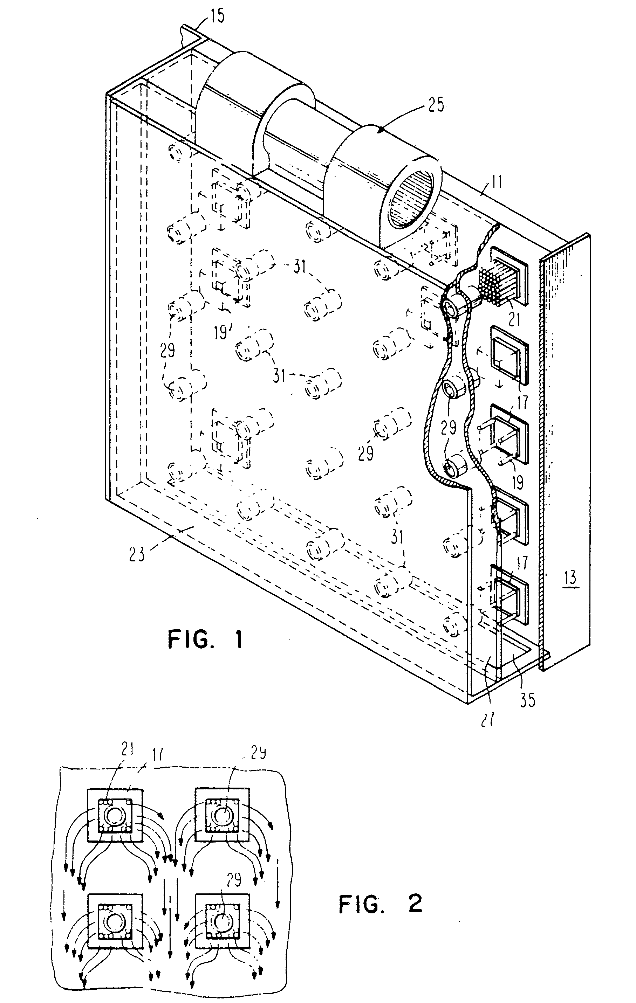

In Fig. 1 ist eine gemäss der Erfindung gestaltete Kühlvorrichtung für elektronische Schaltkreis-Moduln gezeigt, die als Träger eine Schaltkreiskarte 11 enthält, die ihrerseits zwischen Teilen 13 und 15 gehalten ist. Auf der Rückseite der Karte 11 kann die rückwärtige Verdrahtung der Schaltkreise enthalten sein. Sie ist nicht dargestellt. Auf der Vorderseite der Schaltkreiskarte 11 sind eine Vielzahl von elektronischen Schaltkreis-Moduln 17 angeordnet. Auf jedem einzelnen Modul 17 ist eine Wärmeableitvorrichtung 19 vorgesehen. Eine detaillierte Ansicht der Wärmeableitvorrichtung 19 ist mit 21 bezeichnet und dargestellt, und enthält eine Vielzahl von zylindrischer Stangen aus wärmeleitendem Material, die auf der Oberseite des Moduls 17 befestigt sind. In geeignetem Abstand von der Oberfläche der elektronischen Schaltkreisanordnung ist eine Luftkammer 23 angeordnet, an deren Oberseite ein Lüfter 25 angeordnet ist, der zwei Lüfterwalzen enthält. In der Wand 27 der Luftkammer 23, direkt gegenüber den Moduln 17 der elektronischen Schaltkreis-Kartenanordnung, ist eine Vielzahl von Öffnungen 29 vorgesehen. Jede dieser Öffnungen ist mit einer zylindrischen Hülse 31 versehen, so dass ein Auslass bzw. eine Öffnung zwischen der Luftkammer 23 und jedem elektronischen Schaltkreismodul 17 und deren Wärmeableitvorrichtung 19 besteht. Am unteren Teil der Anordnung ist zwischen der Luftkammer 23 und der Trägerkarte 11 ein Schlitz 35 vorgesehen, durch den die erwärmte Luft aus der Anordnung austreten kann.

Vom Gebläse 25 wird Kühlluft in die Luftkammer 23 mit relativ gleichmässigem Druck zugeführt. Durch die Öffnungen 29 mit ihren zylindrischen Hülsen 31 wird ein direkter Luftstrom mit dem Druck innerhalb der Kammer auf jede der Wärmeableitvorrichtungen 19, 21 der elektronischen Schaltkreis-Moduln 17 gerichtet. Der Überdruck an jedem Modul verursacht Turbulenzen innerhalb der Wärmeableitvorrichtung 21, um dadurch die Kühlwirkung der Wärmeableitvorrichtung erheblich zu steigern. Danach wird die unter Druck stehende Luft aus den Bereichen innerhalb der Wärmeableitvorrichtungen 19, 21 herausgeblasen. Dies ist deutlicher in der Darstellung der Fig. 2 zu erkennen, welche die Art darstellt, in der die aus den Wärmeableitvorrichtungen austretende Luft in die Zwischenräume bzw. Kanäle zwischen den einzelnen Moduln herausgelenkt wird.

Aufgrund des Überdrucks, der im Bereich der Moduln und ihrer zugeordneten Luftöffnungen 29 besteht, wird die von anderen Moduln stammende Luft daran gehindert, andere Moduln zu überstreichen. Somit sammelt sich in den Zwischenräumen zwischen den Moduln erwärmte Luft, die abgeführt wird, ohne dabei in den Bereich der Kühlvorrichtungen 19, 21 der Moduln beim Abführen zu gelangen. Die Luftströme in Fig. 2 sind vereinfacht dargestellt, um die Kanalisierung der verbrauchten Luft in den Zwischenräumen zwischen den Moduln zu erläutern. Die Turbulenzen innerhalb der Wärmeableitvorrichtungen der einzelnen Moduln ist demgegenüber komplexer als dargestellt, die Erfahrung hat bewiesen, dass sie die Kühlung in signifikanter Weise verbessert. Dieses zusammen mit der Tatsache, dass die verbrauchte Luft eines bestimmten Moduls nicht wesentlich benachbarte Moduln umstreicht, schafft ein wesentlich verbessertes Kühlsystem, welches bei einem wesentlich niedrigeren Luftdruck arbeitet als bislang. Da die Arbeitsweise bei recht niedrigem Druck erfolgt, ist auch die Lärmentwicklung innerhalb des Systems wesentlich reduziert. Darüber hinaus hat das System einen besseren externen thermischen Widerstandswert und vermeidet ein Anwachsen des Temperaturgradienten, was andererseits über die Oberfläche der elektronischen Schaltkreis-Modulanordnung festzustellen ist. Die erwärmte bzw. verbrauchte Luft wird zwischen den Moduln hindurch und zwischen der Luftkammer 23 sowie der Karte 11 am Boden durch den Schlitz 35 abgeführt.

Wie bereits erwähnt, beinhaltet die erfindungsgemässe Konfiguration zwei wesentliche Vorteile gegenüber dem aus dem Stand der Technik bekannten Reihen-Kühlsystemen. Erstens ist eine effektive Positionsunabhängigkeit für jedes Modul auf der Karte gegeben. Damit ist gemeint, dass jedes Modul an jedem gewünschten Platz auf der Karte angeordnet werden kann, da die Kühlluft nur diesem Modul zugeordnet ist und die Menge durch die Grösse der Öffnung in der Luftkammer bestimmt werden kann. Dies war bei bekannten Reihen-Kühlsysteme nicht der Fall, denn die Kühlluft, welche ein bestimmtes Modul kühlte, hat vorher eines oder mehrere Moduln überstrichen, bevor es am gewünschten Modul ankam. Deshalb musste beispielsweise ein Hochleistungsmodul in der Nähe des Einlasses des Kühlluftstromes angeordnet werden, um die nötige Kühlung erreichen zu können. Es bestand also eine direkte Beziehung zwischen der nötigen Kühlung und der Position des Moduls auf der Karte.

Der zweite wesentliche Punkt ist die Tatsache, dass die erfindungsgemässe Kühlvorrichtung eine sehr hohe Effizienz in der Ausnutzung der zur Verfügung stehenden Kühlluft aufweist. Frühere Systeme hatten üblicherweise einen signifikanten Leckverlust, da die Luft um und durch die Moduln in Reihenfluss geleitet wurde. Die erfindungsgemässe Vorrichtung sieht dagegen eine relativ luftdichte Kammer vor und nachdem die Luft aus dieser heraus auf die Moduln zum Kühlen gelenkt ist, besteht kein Erfordernis mehr, die Luftdichtigkeit innerhalb des Systems aufrechtzuerhalten, da die Luft bereits ihren Kühlzweck erfüllt hat. Demgemäss wird fast sämtliche in Bewegung gesetzte Luft zum Kühlen eines zugehörigen Moduls verwendet.

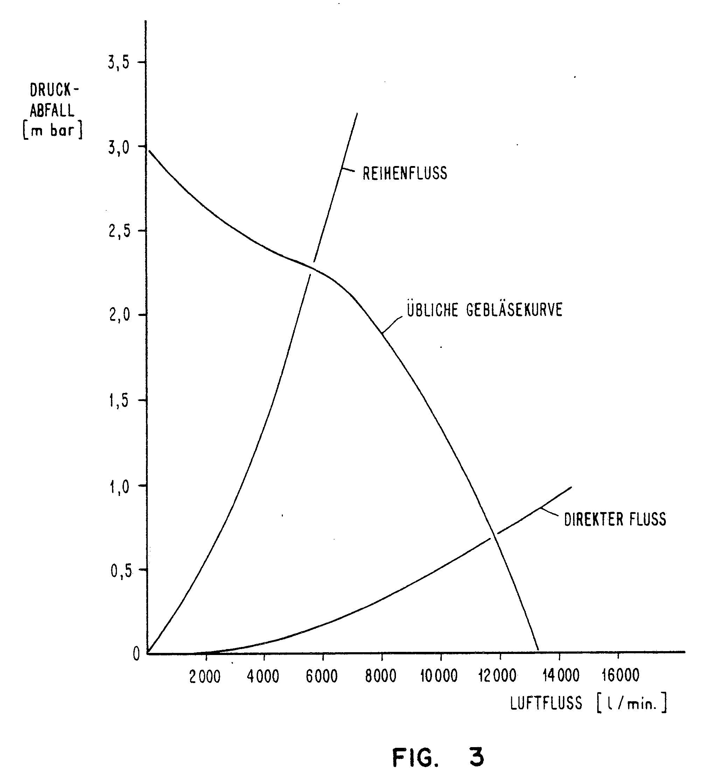

In Fig. 3 ist die relative Luftimpedanzkurve für ein Reihenfluss-Luftkühlsystem angegeben, wie sie üblich im Stand der Technik sind und zum anderen die Direktfluss-Kurve für ein System gemäss vorliegender Erfindung. Die Kurve stellt den Luftfluss in Litern pro Minute entlang der horizontale X-Achse dar und den Druckabfall in mbar auf der senkrechten y-Achse. Die durchgehende Kurve zwischen der x- und der y-Achse stellt die übliche Gebläsekurve dar, d.h., die Arbeitskurve eines Lüfters. Es ist beispielsweise bekannt, dass bei steigendem Widerstand gegen die Luftbewegung (Anstieg des Druckabfalls) sich der Luftfluss vermindert. Deswegen hat ein bestimmter Lüfter seine eigene zugeordnete Arbeitskurve. Die Kurve zeigt in einem Beispiel, dass bei direktem Fluss-System ein Luftfluss von etwa 12000 Litern pro Minute einen Staudruck von ca. 0,75 mbar erzeugt. Für ein ähnliches Reihenflusssystem erzeugt ein Luftfluss von ca. 6000 Litern pro Minute einen Staudruck von etwa 2,25 mbar. Bei einer gegebenen Konfiguration bedeutet dies beispielsweise, dass bei einem System mit direktem Anströmen, d.h. direktem Fluss mit etwa 510 Litern pro Minute und Modul eine bestimmte Kühlung erreicht wird, während bei einem Reihenfluss-System unter der Annahme von etwa 20% Nebenflussverlust, in etwa 910 Liter pro Minute und Modul erforderlich wären, um dieselbe Kühlwirkung zu erreichen. Dies zeigt, dass nicht nur ein grösserer Luftfluss bei einem Reihenflusssystem nötig ist, sondern auch, dass dieses bei einem wesentlich höheren Staudruck arbeitet, wodurch der akustische Lärm, der diesem System innewohnt, hoch ist.

Entsprechend der möglichen unterschiedlichen Wärmeentwicklung in einzelnen Moduln aufgrund deren Leistungsverbrauch, kann der Luftfluss, der diesen Moduln zugeführt wird, verändert werden. Dies kann beispielsweise durch Verändern der Grösse der Öffnungen 29 in der Wand der Luftkammer 23 erfolgen oder durch veränderbare Öffnungen 29, um den Durchfluss zu begrenzen. Die für die Wärmeableitvorrichtungen 19 verwendeten Gestaltungen können sehr unterschiedlich sein. Beispielsweise können radial strahlenförmig angeordnete Rippen, oder dendritenförmige Stäbe oder sogar gerade feste Deckel verwendet werden. Dies hängt vom jeweiligen Verwendungszweck ab.

**Patentansprüche**

1. Kühlvorrichtung für elektronische Schaltkreis-Moduln (17), von denen mehrere auf einem Träger (11) angeordnet sind, wobei als Kühlmittel Luft verwendet wird, mit einer Luftkammer (23), der Kühlluft mit relativ konstantem Druck zugeführt wird und die mit einer Reihe von Auslässen (29, 31) gegenüber den Moduln (17) versehen ist, wobei die Kühlluft beim Austritt aus den Auslässen (29, 31) direkt die zugeordneten Moduln (17) anbläst, dadurch gekennzeichnet, dass die von der Kühlluft angeblasene Oberfläche der Moduln (17) mit einer Turbulenzen erzeugenden Wärmeableitvorrichtung (19) versehen ist, dass der Kühlluftstrom unter Turbulenzbildung durch die Wärmeableitvorrichtung (19, 21) hindurch auf die Oberfläche der Moduln (17) geführt wird und dass die in der Wärmeableitvorrichtung (19, 21) erwärmte Luft durch kanalartige Zwischenräume zwischen den Moduln (17) abgeleitet wird, ohne auf andere, benachbarte Moduln wesentlich zu treffen.

2. Kühlvorrichtung nach Anspruch 1, dadurch gekennzeichnet, dass die Anzahl der Auslässe (29) der Anzahl der auf einem Träger (11) möglichen Moduln (17) entspricht.

3. Kuhlvorrichtung nach Anspruch 1 oder 2, dadurch gekennzeichnet, dass die Auslässe (29) runde Öffnungen sind und sie auf der den Moduln (17) zugekehrten Seite mit zylinderförmigen Hülsen (31) versehen sind, deren Auslássende unmittelbar in der Nähe des zugeordneten Moduls (17) angeordnet ist.

4. Kühlvorrichtung nach einem der vorigen Ansprüche, dadurch gekennzeichnet, dass zumindest ein Auslass (29, 31) mit Mitteln zum Verändern des Volumens der durchströmenden Kühlluft versehen ist, um die Menge der auf das zugehörige Modul (17) auftreffenden Kühlluft zu regulieren.

5. Kühlvorrichtung nach einem der vorigen Ansprüche, dadurch gekennzeichnet, dass die als Träger dienende Karte (11), auf der die Moduln (17) angeordnet sind, luftundurchlässig ist, um einen gewissen Staudruck zu erzeugen.

6. Kühlvorrichtung nach einem der vorigen Ansprüche, dadurch gekennzeichnet, dass die aus den Auslässen (29, 31) austretenden Kühlluftströme im wesentlichen parallel zueinander sind.

7. Kühlvorrichtung nach einem der vorigen Ansprüche, dadurch gekennzeichnet, dass die Auslässe (29, 31) im selben Muster bzw. derselben Anordnung in der Wand der Luftkammer (23) angeordnet sind, wie die Moduln (17) auf ihrem Träger (11).

8. Kühlvorrichtung nach einem der Ansprüche 1 bis 7, dadurch gekennzeichnet, dass die Wärmeableitvorrichtung (19) aus einer Vielzahl von der Oberfläche der Moduln (17) abstehender stabförmiger Kühlkörper (21) besteht.

**Revendications**

1. Dispositif de refroidissement pour modules de circuit électronique (17) dont plusieurs sont agencés sur un tableau (11), de l'air étant utilisé comme réfrigérant, ce dispositif comportant une chambre pneumatique (23) dans laquelle l'air de refroidissement est appliqué sous une pression relativement constante et qui est équipée avec un certain nombre de sorties (29, 31) situées en face des modules (17), l'air de refroidissement, lors de son échappement par les sorties (29, 31), frappant directement les modules correspondants (17), ce dispositif étant caractérisé en ce que la surface du module (17) frappée directement par l'air de refroidissement est équipée d'un dispositif d'évacuation thermique générateur de turbulences (19), en ce que le courant d'air de refroidissement formant des turbulences, est guidé au travers du dispositif d'évacuation thermique (19, 21) sur la surface des modules (17), et en ce que l'air réchauffé dans le dispositif d'évacuation thermique (19, 21) est entraîné au travers d'espaces en forme de canaux situés entre les modules (17) sans pratiquement frapper d'autres modules adjacents.

2. Dispositif de refroidissement selon la revendication 1 caractérisé en ce que le nombre des sorties (29) correspond au nombre des modules (17) sur un tableau (11).

3. Dispositif de refroidissement selon la revendication 1 ou 2, caractérisé en ce que les sorties (29) sont des ouvertures circulaires et en ce qu'elles comportent sur leur côté faisant face aux modules (17), des cylindres creux (31) dont la sortie est disposée au voisinage direct du module associé (17).

4. Dispositif de refroidissement selon l'une quelconque des revendications précédentes, caractérisé en ce qu'au moins une sortie (29, 31) est équipée de moyens pour modifier le volume de l'air de refroidissement transporté de façon à régulariser la quantité d'air de refroidissement frappant le module associé (17).

5. Dispositif de refroidissement selon l'une quelconque des revendications précédentes, caractérisé en ce que le tableau (11) sur lequel les modules (17) sont agencés, est imperméable à l'air pour obtenir une pression d'impact prédéterminé.

6. Dispositif de refroidissement selon l'une quelconque des revendications précédentes, caractérisé en ce que les courants d'air de refroidissement sortant par les sorties (29, 31) sont pratiquement parallèles.

7. Dispositif de refroidissement selon l'une quelconque des revendications précédentes, caractérisé en ce que les sorties (29, 31) sont agencées dans la paroi de la chambre pneumatique (23) dans la même configuration que les modules (17) sur le tableau (11).

8. Dispositif de refroidissement selon l'une quelconque des revendications 1 à 7, caractérisé en ce que le dispositif d'évacuation thermique (19) consiste en une pluralité d'éléments de refroidissement en forme de tige (21) faisant saillie depuis la surface des modules (17).

**Claims**

1. Cooling apparatus for electronic circuit modules (17) of which several are arranged on one carrier (11), with air being used as a coolant, with an air chamber (23) to which cooling air is applied at a relatively constant pressure, and which is equipped with a number of outlets (29, 31) opposite the modules (17), the cooling air upon its exit from the outlets (29, 31) impinging directly on the associated modules (17), characterized in that the module (17) surface directly impinged on by the cooling air is equipped with a turbulence-generating heat exhaust (19), that the stream of cooling air, forming turbulences, is guided through the heat exhaust (19, 21) onto the surface of the modules (17), and that the air heated in the heat exhaust (19, 21) is transported through channellike spaces between the modules (17) without substantially impinging on other adjacent modules.

2. Cooling apparatus as claimed in claim 1, characterized in that the number of outlets (29) correspond to the number of modules (17) on one carrier (11).

3. Cooling apparatus as claimed in claim 1 or 2, characterized in that the outlets (29) are circular openings, and that on their side facing the modules (17) they have hollow cylinders (31) whose outlet is arranged in the direct vicinity of the associated module (17).

4. Cooling apparatus as claimed in any one of the preceding claims, characterized in that at least one outlet (29, 31) is equipped with means for altering the volume of the the transported cooling air so as to regulate the quantity of the cooling air impinging on the associated module (17).

5. Cooling apparatus as claimed in any one of the preceding claims, characterized in that the card (11) serving as a carrier on which the modules (17) are arranged is impermeable to air to produce a predetermined impact pressure.

6. Cooling apparatus as claimed in any one of the preceding claims, characterized in that the cooling air streams exiting from the outlets (29, 31) are substantially parallel.

7. Cooling apparatus as claimed in any one of the preceding claims, characterized in that the outlets (29, 31) are arranged in the same pattern or the same arrangement, respectively, in the wall of the air chamber (23) as the modules (17) on their carrier (11).

8. Cooling apparatus as claimed in any one of claims 1 to 7, characterized in that the heat exhaust (19) consists of a plurality of rod-like cooling bodies (21) protruding from the surface of the modules (17).

FIG. 1

FIG. 2

FIG. 3